# EUROPÄISCHE PATENTANMELDUNG

(11) **EP 4 626 155 A1**
(43) Veröffentlichungstag der Anmeldung: **01.10.2025**
(21) Anmeldenummer: 25166412.4
(22) Anmeldetag: 26.03.2025
(51) Int. Cl.: H05K 5/06, H05K 9/00, H01M 50/202, H01M 50/24, H05K 5/00

(54) **GEHÄUSE MIT DICHTUNG**

(30) Priorität: 26.03.2024 DE 102024108587
(71) Anmelder: POLYTEC PLASTICS Germany GmbH & Co. KG, 49393 Lohne (DE)
(72) Erfinder: van Gilst, Walter, 4462 PC Goes (NL); Huckle, Jens, 76676 Graben-Neudorf (DE); Burkert, Tobias, 49080 Osnabrück (DE); Buck, Michael, 49401 Damme (DE); Soares, Jorge, 48493 Wettringen (DE); Leson, Christoph, 49413 Dinklage (DE); Berding, Christian, 49393 Lohne (DE)
(74) Vertreter: dompatent von Kreisler Selting Werner - Partnerschaft von Patent- und Rechtsanwälten mbB

(57) **Zusammenfassung**

Bei einem Gehäuse (1) vorzugsweise für die Aufnahme von Elektrobauteilen, mit
- zumindest einem ersten Gehäuseteil (2) und zumindest einem zweiten Gehäuseteil (4), die in einem zusammengesetzten Zustand ein geschlossenes Gehäuse (1) bilden,
- wobei zumindest das erste Gehäuseteil (2) einen umlaufenden Rand (8) oder umlaufende Kontur im Randbereich aufweist,
- zumindest ein komprimierbares Element (6, 60), das zumindest auf dem umlaufenden Rand (8) oder in oder an der umlaufenden Kontur angeordnet ist, und das im zusammengesetzten Zustand zwischen dem ersten Gehäuseteil (2) und dem zweiten Gehäuseteil (4) angeordnet ist,
**dadurch gekennzeichnet,**
dass zumindest eine erste elektrisch leitenden Lage (10) vorgesehen ist, wobei im zusammengesetzten Zustand des Gehäuses (1) die erste elektrisch leitende Lage (10) die Innenseite (13) des ersten Gehäuseteils (2) abdeckt.

## Beschreibung

Die Erfindung betrifft ein Gehäuse vorzugsweise für die Aufnahme von Elektrobauteilen nach Anspruch 1.

Es sind Gehäuse für die Aufnahme von Elektrobauteilen beispielsweise in einem Kraftfahrzeug bekannt, die zumindest ein erstes Gehäuseteil und zumindest ein zweites Gehäuseteil aufweisen, die in einem zusammengesetzten Zustand ein geschlossenes Gehäuse bilden. Zumindest das erste Gehäuseteil weist einen umlaufenden Rand oder umlaufende Kontur im Randbereich auf und es ist zumindest eine umlaufende Dichtung vorgesehen, die auf dem umlaufenden Rand oder in oder an der umlaufenden Kontur angeordnet ist und die im zusammengesetzten Zustand zwischen dem ersten Gehäuseteil und dem zweiten Gehäuseteil angeordnet ist. Aufgrund solcher Dichtungen ist das Gehäuse nach außen hin dicht. So können beispielsweise Flüssigkeiten, Dreck oder Stäube von außen nicht in das Gehäuseinnere eindringen und somit die Bauteile schützen. Andererseits kann auch verhindert werden, dass beispielsweise Flüssigkeiten, die aus den im Inneren des Gehäuses befindlichen Bauteilen austreten, nicht aus dem Gehäuse austreten.

Weiter ist es auch bekannt, in einem Gehäuse befindliche Elektrobauteile elektromagnetisch abzuschirmen, um beispielsweise Störeinflüsse zu reduzieren. Solche Maßnahmen sind unter dem Begriff Elektromagnetische Verträglichkeit (EMV) bekannt.

Um Einrichtungen mit Gehäusen elektromagnetisch abzuschirmen, müssen das erste und das zweite Gehäuseteil entweder selbst elektrisch leitend sein oder eine elektrisch leitende Schicht aufweisen, wie beispielsweise eine Beschichtung. Zudem wird in solchen Fällen häufig eine Dichtung vorgesehen, die elektrisch leitend ist. Dabei werden in der Dichtung häufig teure leitfähige Füllstoffe zugesetzt, so dass das erste und das zweite Gehäuseteil über die Dichtung elektrisch leitend miteinander verbunden werden können oder es werden elektrisch leitende Verbindungselemente z.B. Schrauben in geringen Abständen zueinander und entsprechend hoher Anzahl zur elektrischen Verbindung beider Gehäuseteile eingesetzt, um so eine ausreichende elektromagnetische Abschirmung der in dem Gehäuse befindlichen Bauteile auch an den Schnittstellen der Gehäuseteile zu schaffen. Diese Lösungen nach dem Stand der Technik sind folglich sehr teuer uns weisen an den Gehäuseschnittstellen eine verminderte elektromagnetische Abschirmung aufgrund der geringeren elektrischen Leitfähigkeit gefüllter elektrisch leitfähiger Dichtungen bzw. aufgrund der Spalten zwischen den Schrauben zur elektrischen Verbindung der Gehäuseteile auf.

Aufgabe der vorliegenden Erfindung ist es jedoch, ein Gehäuse für die Aufnahme von Elektrobauteilen zu schaffen, das auf einfache Art und Weise kostengünstig herstellbar ist.

### Zur Lösung dieser Aufgabe dienen die Merkmale des Anspruchs 1

Gemäß der vorliegenden Erfindung ist ein Gehäuse vorzugsweise für die Aufnahme von Elektrobauteilen vorgesehen, mit
- zumindest einem ersten Gehäuseteil und zumindest einem zweiten Gehäuseteil, die in einem zusammengesetzten Zustand ein geschlossenes Gehäuse bilden,
- wobei zumindest das erste Gehäuseteil einen umlaufenden Rand oder umlaufende Kontur im Randbereich aufweist,
- zumindest ein komprimierbares Element, das zumindest auf dem umlaufenden Rand oder in oder an der umlaufenden Kontur angeordnet ist, und das im zusammengesetzten Zustand zwischen dem ersten Gehäuseteil und dem zweiten Gehäuseteil angeordnet ist.

Die Erfindung sieht in vorteilhafter Weise vor, dass zumindest eine erste elektrisch leitende Lage vorgesehen ist, wobei im zusammengesetzten Zustand des Gehäuses die elektrisch leitende Lage die Innenseite des ersten Gehäuseteils abdeckt.

Auf diese Weise kann zum Beispiel das erste und/oder das zweite Gehäuseteil nichtleitend ausgeführt sein. Das Gehäuse kann beispielsweise aus Kunststoff hergestellt werden. Es können somit einfache Gehäuse und Dichtungen hergestellt werden, ohne dass das Gehäuse oder die Dichtung zusätzlich leitende Füllstoffe ausweisen müssen.

Das komprimierbare Element kann ein elastisches Material wie beispielsweise ein Elastomer aufweisen.

Mithilfe des komprimierbaren Elements kann das Gehäuse dicht gegenüber der Umgebung sein. So können beispielsweise Flüssigkeiten, Dreck oder Stäube von außen nicht in das Gehäuseinnere eindringen und somit sind die Bauteile im Inneren des Gehäuses geschützt.

Die erste elektrisch leitende Lage kann im Bereich des umlaufenden Rands sowohl das erste Gehäuseteil als auch das zweite Gehäuseteil kontaktieren.

Zumindest ein Kantenbereich der ersten elektrisch leitenden Lage kann aufgerollt oder umgefaltet sein.

Die erste elektrisch leitende Lage kann mit dem aufgerollten oder umgefalteten Kantenbereich sowohl das erste Gehäuseteil als auch das zweite Gehäuseteil kontaktieren.

Die erste elektrisch leitende Lage kann mit dem aufgerollten oder umgefalteten Kantenbereich mit dem komprimierbaren Element in Kontakt stehen, wobei das komprimierbare Element vorzugsweise als Dichtung ausgebildet ist.

In dem aufgerollten oder umgefalteten Kantenbereich kann ein elastisches Teil angeordnet sein, mittels dessen die elektrisch leitende Lage sowohl gegen das erste Gehäuseteil als auch gegen das zweite Gehäuseteil drückbar ist.

Das zumindest eine komprimierbare Element und die zumindest eine erste elektrisch leitende Lage können eine gemeinsame Schicht bilden, die als Flachmaterial ausgebildet ist, so dass die als Flachmaterial ausgebildete Schicht in Dickenrichtung verpressbar ist.

Das zumindest eine komprimierbare Element und die zumindest eine erste elektrisch leitende Lage können ein Verbund-Flachmaterial bilden, wobei zumindest das als Schicht ausgebildete komprimierbare Element und/oder die erste elektrisch leitende Lage in Dickenrichtung verpressbar sind.
dass die zumindest eine elektrisch leitende Lage (10) das zumindest eine als komprimierbare Schicht ausgebildete komprimierbare Element (60) insbesondere im Bereich des umlaufenden Randes oder in oder an der umlaufenden Kontur zumindest teilweise umschlingt

Das zumindest eine als komprimierbare Schicht ausgebildete komprimierbare Element kann die zumindest eine elektrisch leitende Lage insbesondere im Bereich des umlaufenden Randes oder in oder an der umlaufenden Kontur zumindest teilweise umschlingen.

Das zumindest eine als komprimierbare Schicht ausgebildete komprimierbare Element kann Einkerbungen aufweisen.

Die zumindest eine elektrisch leitende Lage kann das zumindest eine als komprimierbare Schicht ausgebildete komprimierbare Element insbesondere im Bereich des umlaufenden Randes oder in oder an der umlaufenden Kontur zumindest teilweise umschlingen.

Das zumindest eine komprimierbare Element kann als Dichtung, vorzugsweise als umlaufende Dichtung ausgebildet sein, wobei die Dichtung und die erste elektrisch leitenden Lage in Kontakt miteinander stehen.

Die als umlaufende Dichtung ausgebildete Dichtung kann dabei vorzugsweise mit einem umlaufenden Randbereich der ersten elektrischen Lage verbunden sein, so dass die Dichtung und die Lage zusammen eine Fläche bilden, die auf dem erste Gehäuseteil platzierbar ist, wobei die umlaufende Dichtung dann auf dem umlaufenden Rand des ersten Gehäuseteils angeordnet werden kann. Auf diese Weise kann im zusammengesetzten Zustand nicht nur die Dichtung zwischen dem ersten Gehäuseteil und dem zweiten Gehäuseteil angeordnet sein, sondern auch ein Teil der ersten elektrisch leitenden Lage.

Die Dichtung kann adhäsiv auf dem ersten Gehäuseteil angebunden sein. Die Dichtung kann auf dem ersten Gehäuseteil aufgesetzt sein.

Der Kontakt zwischen Dichtung und elektrisch leitender Lage kann durch zumindest partielles Aufeinanderlegen hergestellt sein und/oder es kann eine formschlüssige und/oder kraftschlüssige und/oder adhäsive Verbindung als Kontakt vorliegen. Die Dichtung kann stoff- und/oder formschlüssig mit der elektrisch leitenden Lage verbunden sein.

Die elektrisch leitende Lage kann beispielsweise mit der Dichtung mittels einer Klebeschicht verbunden sein.

Die Dichtung und die elektrisch leitende Lage können eine gemeinsame Baugruppe bilden.

Die elektrisch leitende Lage kann beispielsweise die Form einer Folie, Blechs, Gewebes, Vlieses, Schicht oder eine Kombination aus den genannten Formen aufweisen. Die elektrisch leitende Lage kann zumindest teilweise aus einem metallischen Werkstoff oder Kohlenstoff-haltigen Werkstoff bestehen.

Die Dichtung kann zumindest im Bereich, in dem die Dichtung mit der elektrisch leitenden Lage in Kontakt ist, im zusammengesetzten Zustand zumindest teilweise zusammengedrückt sein.

Dadurch, dass die Dichtung teilweise zusammengedrückt wird, insbesondere in dem Bereich, in dem die elektrisch leitende Lage mit der Dichtung in Kontakt ist, kann eine lokale Verpressung im zusammengesetzten Zustand bewirkt werden, wobei dadurch Toleranzabweichungen unter anderem in Form von Unebenheiten zwischen dem ersten Gehäuseteil und dem zweiten Gehäuseteil ausgeglichen werden können.

Wenn die elektrisch leitende Lage direkt mit der Dichtung verbunden ist, kann auch eine formschlüssige Positionierung im Gehäuse stattfinden.

Die Dichtung weist vorzugsweise ein elastisches Material, wie beispielsweise ein Elastomer auf. Das elastische Material kann dabei elastisch verformbar sein. Das heißt, die Dichtung formt sich nach einer Belastung wieder in den Ausgangszustand zurück.

Unter einer Dichtung im Sinne der vorliegenden Erfindung wird ein Element verstanden, dass ungewollte Stoffübergänge von einem Ort zu einem anderen verhindert oder begrenzt. Im vorliegenden Fall soll die Dichtung insbesondere verhindern, dass flüssige Stoffe oder Stäube in das Gehäuse eindringen oder herauskommen können.

Die Dichtung kann zumindest einen Anbindungs-Bereich aufweisen, insbesondere eine Dichtungslasche aufweisen, mit dem die elektrisch leitende Lage in Kontakt ist.

Der Anbindungs-Bereich ist lediglich ein Bereich der Dichtung, der mit der elektrisch leitenden Lage in Kontakt ist.

Die Dichtung, insbesondere der Anbindungs-Bereich, und die elektrisch leitende Lage können im zusammengesetzten Zustand zumindest teilweise einander überlappend angeordnet sein.

Der Anbindungs-Bereich kann ein an die Dichtung angeformter Bereich sein, der im zusammengesetzten Zustand auf der der Gehäuseinnenseite zugewandten Seite der Dichtung angeordnet ist.

Der Anbindungs-Bereich kann ein Teil der Dichtung sein, der vorzugsweise in Relation zu dem restlichen Teil der Dichtung eine geringere Höhe aufweist, wobei der Anbindungs-Bereich vorzugsweise eine Lasche ist.

Der Anbindungs-Bereich kann sich über die vollständige Breite der Dichtung erstrecken, d.h. über die dem zweiten Gehäuseteil zugewandten Oberfläche der Dichtung.

Der zumindest eine Anbindungs-Bereich kann ein umlaufender Teil der Dichtung sein. Es können mehrere umlaufende Anbindungs-Bereiche vorgesehen sein, die vorzugsweise entlang des Dichtungsverlaufs im Wesentlichen gleichmäßige Abstände zueinander aufweisen.

Die Dichtung, insbesondere der Anbindungs-Bereich kann im zusammengesetzten Zustand zumindest teilweise zusammengedrückt sein.

Die Dichtung, insbesondere der Anbindungs-Bereich kann zumindest einen, vorzugsweise mindestens zwei Vorsprünge aufweisen.

Der zumindest eine Vorsprung kann im zusammengesetzten Zustand zumindest teilweise zusammengedrückt sein. Dadurch, dass die Dichtung und die elektrisch leitende Lage vorzugsweise einander überlappen und vorzugsweise in dem Bereich angeordnet sind, in die Dichtung Vorsprünge aufweist und diese Vorsprünge im zusammengesetzten Zustand zusammengedrückt sein können, ist sichergestellt, dass die elektrisch leitende Lage mit dem zweiten Gehäuseteil oder einer weiteren elektrisch leitenden Lage des zweiten Gehäuseteils stets in Kontakt ist.

Der zumindest eine Vorsprung kann in der Richtung hervorstehen, in der im zusammengesetzten Zustand die auf die Dichtung wirkende Kraft einwirkt.

Das zweite Gehäuseteil kann elektrisch leitend sein. Das zweite Gehäuseteil kann beispielsweise ein Gehäuseteil aus Metall sein.

Alternativ oder zusätzlich kann eine zweite elektrisch leitende Lage vorgesehen sein, die im zusammengesetzten Zustand die Innenseite des zweiten Gehäuseteils abdeckt.

Die erste und die zweite elektrisch leitende Lage können im zusammengesetzten Zustand miteinander verbunden sein.

Die erste und die zweite elektrisch leitende Lage können auch im nicht zusammengesetzten Zustand miteinander verbunden sein.

Die Dichtung kann in wenigstens einen Bereich aus wenigstens zwei zueinander beabstandeten Dichtbereichen bestehen, zwischen denen wenigsten ein geschlossenes Volumen ausgebildet ist, wobei zwischen den wenigstens zwei beabstandeten Dichtbereichen wenigstens eine Prüfdruckbohrung für die Aufbringung eines Differenzdrucks für die Dichtheitsprüfung der Dichtung vorgesehen sein kann.

Die wenigstens zwei zueinander beabstandeten Dichtbereiche können über wenigstens einen Stegbereich miteinander verbunden sein und die wenigstens zwei zueinander beabstandeten Dichtbereiche können mit dem wenigstens einen Stegbereich vorzugsweise ein H-förmiges Querschnittsprofil (60) ausbilden.

Es können Gehäuse zur Aufnahme zumindest einer Batteriezelle umfassend wenigstens eine Dichtung und wenigstens eine elektrisch leitfähige Lage vorgesehen sein, zur Abdichtung und elektromagnetischen Abschirmung der zumindest einen in dem Batteriegehäuse aufgenommenen Batteriezelle und elektrischen Komponenten.

Die Dichtung und die wenigstens eine elektrisch leitfähige Lage sind vorzugsweise zur Abdichtung und elektromagnetischen Abschirmung der zumindest einen in dem Batteriegehäuse aufgenommenen Batteriezelle und elektrischen Komponenten ausgebildet.

Es kann eine Dichtung zum Einsetzen im einem Gehäuse vorgesehen sein, wobei die Dichtung eine umlaufende Dichtung sein kann, die mit zumindest einer ersten elektrisch leitenden Lage verbunden sein kann.

Die umlaufende Dichtung kann mit dem umlaufenden Randbereich der ersten elektrisch leitenden Lage verbunden sein.

Die Dichtung kann einen Anbindungs-Bereich aufweisen, mit dem die elektrisch leitende Lage verbunden ist und wobei der Anbindungs-Bereich und die elektrisch leitende Lage vorzugsweise einander überlappend angeordnet sein können.

Die Dichtung als Teil dieser Erfindung kann auf unterschiedliche Weise hergestellt sein. Die Dichtung kann bevorzugt in einem diskontinuierlichen formgebenden Prozess hergestellt sein, beispielsweise im Elastomer-Spritzguss-Verfahren.

Die wenigstens eine Dichtung kann bevorzugt auch flüssig auf eines oder mehrere Gehäuseteile aufgetragen sein, beispielsweise als thermoplastische Elastomerdichtung bzw. Hotmelt-Dichtung oder auch als chemisch vernetzende Dichtung.

Desweiteren kann die Dichtung bevorzugt in einem kontinuierlichem formgebenden Endlos-Prozess hergestellt sein, beispielsweise im kostengünstigen Elastomer-Extrusions-Verfahren.

Um eine im kostengünstigen Extrusions-Verfahren hergestellte Dichtung für die umlaufende Abdichtung verwenden zu können, muss sich diese entweder dem bestimmungsgemäßen Dichtungsverlauf insbesondere in Eckbereichen folgend an einem Gehäuseteil aufbringen lassen oder die Dichtung muss aus mehreren Stücken zusammengesetzt werden, wodurch sich die Kosten und sich die Schnittstellenzahl erhöhen.

Insbesondere breitere Dichtungen oder die bevorzugt um den Anbindungs-Bereich zur elektrisch leitenden Lage verbreiterte erfindungsgemäße bevorzugt einstückige extrudierte Dichtung lassen sich mit zunehmender Breite insbesondere in den Eckbereichen nicht ohne eine Deformation des Funktionsbestimmenden Dichtungs-Querschnitts auf einem der Gehäuseteile aufbringen. Um funktionsbeeinträchtigende Deformationen insbesondere in den Eckbereichen zu vermeiden, kann die Dichtung in den Eckbereichen vorzugsweise über zumindest einen Anteils der Breite des vorzugsweise vorhandenen Anbindungs-Bereichs eingeschnitten werden und erst dann für die Ausbildung der Ecke geknickt oder vorzugsweise über einen bogenförmigen Verlauf abgewinkelt bzw. umgelenkt oder in einen vorgegebenen Kurvenverlauf gebracht werden, so dass in den Eckbereichen der Dichtung keine Quetschungen oder nur eine minimale lokale Deformationen des Dichtungsmaterials durch die Bildung der Eckbereiche stattfindet. Die Form und die Größe des Einschnitts kann durch Versuche bestimmt werden, so dass die lokale Deformation des Dichtungsmaterials minimiert ist und andererseits eine ausreichende Abdichtung über eine ausreichende Dichtungsbreite in diesem Bereich gewährleistet ist. Die elektrisch leitende Lage kann, nach dem die Eckbereichsbildung ausgeführt worden ist, an die Dichtung stoff- und/oder formschlüssig angebracht werden.

Verwendung eines Gehäuses nach einem der Ansprüche 1 bis 14 zur Temperierung von elektrischen Komponenten, wie beispielsweise elektrischer Energiespeicher und/oder elektrischer Schaltungen.

Verwendung nach Anspruch 15 zur Temperierung elektrischer Energiespeicher in Form von Rundzellen, prismatischer Zellen oder flacher taschenförmiger Batteriezellen.

Verwendung nach Anspruch 15 zur Temperierung von Energiespeichern einer stationären Anwendung oder eines Kraftfahrzeuges, eines Flugzeuges oder eines Schiffes.

Im Folgenden werden unter Bezugnahme auf die Zeichnungen Ausführungsbeispiele der vorliegenden Erfindung näher erläutert.
- Fig. 1: zeigt ein Gehäuse gemäß der vorliegenden Erfindung,
- Fig. 2: zeigt ein Ausschnitt des Gehäuses gemäß Fig. 1 mit Dichtung und elektrisch leitfähiger Lage,
- Fig. 3: zeigt das Ausführungsbeispiel gemäß Fig. 2 im nicht zusammengesetzten Zustand,
- Fig. 4: zeigt ein alternatives Ausführungsbeispiel, bei dem die Dichtung lediglich einen Vorsprung aufweist,
- Fig. 5: zeigt einen Eckbereich der Dichtung, wie er im Bereich einer Ecke des Gehäuses vorgesehen sein kann,
- Fig. 6: zeigt eine weiteres Ausführungsbeispiel einer erfindungsgemäßen Dichtung deren Profilausbildung eine vorteilhafte Dichtprüfung der Dichtung erlaubt,
- Fig. 7: zeigt eine weiteres Ausführungsbeispiel, bei dem das komprimierbare Element und die zumindest eine erste elektrisch leitende Lage eine gemeinsame Schicht bilden,
- Fig. 8: zeigt eine weiteres Ausführungsbeispiel, bei dem das zumindest eine komprimierbare Element 60 und die zumindest eine erste elektrisch leitende Lage 10 als Verbund-Flachmaterial ausgebildet sind,
- Fig. 9: zeigt eine weiteres Ausführungsbeispiel, bei dem das als Schicht ausgebildete komprimierbare Element die zumindest eine elektrisch leitende Lage insbesondere im Bereich des umlaufenden Randes oder in oder an der umlaufenden Kontur zumindest teilweise umschlingt.
- Fig. 10: zeigt eine weiteres Ausführungsbeispiel, bei dem die zumindest eine elektrisch leitende Lage 10 die zumindest eine komprimierbare Schicht 60 insbesondere im Bereich des umlaufenden Randes 8 oder in oder an der umlaufenden Kontur zumindest teilweise umschlingt
- Fig. 11: zeigt eine weiteres Ausführungsbeispiel, bei dem zumindest ein Kantenbereich 200 der ersten elektrisch leitenden Lage 10 aufgerollt oder umgefaltet ist.

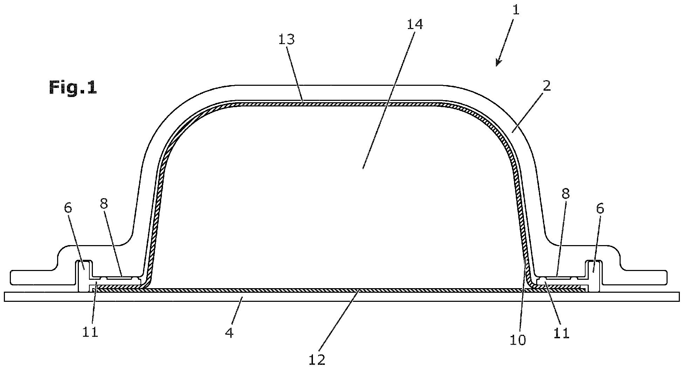

Fig. 1 zeigt ein erfindungsgemäßes Gehäuse 1. Das Gehäuse ist vorzugsweise dafür geeignet Elektrobauteile aufzunehmen. Das Gehäuse 1 weist zumindest ein erstes Gehäuseteil 2 und zumindest ein zweites Gehäuseteil 4 auf, die im montierten Zustand wenigstens ein Fassungsvolumen zur Aufnahme der vorzugsweise im Wesentlichen elektronischen Teile umschließen, wobei beispielsweise das erste Gehäuseteil 2 das Fassungsvolumen im Wesentlichen aufnimmt oder das zweite Gehäusebauteil 4 das Fassungsvolumen im Wesentlichen aufnimmt oder beide Gehäusebauteile jeweils einen Anteil des Fassungsvolumens aufnehmen.

Als Elektrobauteile können beispielsweise elektrochemische Energiespeicherzellen vorgesehen sein.

In Fig. 1 ist das erste und das zweite Gehäuseteil 2, 4 in einem zusammengesetzten Zustand dargestellt. In diesem Zustand bilden sie ein geschlossenes Gehäuse 1, das im Inneren einen Bereich 14 bildet, in dem beispielsweise Elektrobauteile aufgenommen werden können.

Das erste Gehäuseteil 2 weist vorzugsweise einen umlaufenden Rand 8 auf. Es kann zumindest ein komprimierbares Element vorgesehen sein, das auf den umlaufenden Rand 8 angeordnet sein kann und das im zusammengesetzten Zustand zwischen dem ersten Gehäuseteil 2 und dem zweiten Gehäuseteil 4 angeordnet sein kann. Das komprimierbare Element kann eine Dichtung sein. Durch das als Dichtung ausgebildete komprimierbare Element 6 kann das Gehäuse 1 dicht gegenüber der Umgebung sein. So können beispielsweise Flüssigkeiten, feste Verunreinigungen oder Stäube von außen nicht in das Gehäuseinnere eindringen und somit sind die Bauteile im Inneren des Gehäuses geschützt. Andererseits kann auch verhindert werden, dass beispielsweise Flüssigkeiten, die aus den im Inneren des Gehäuses befindlichen Bauteil austreten, nicht aus dem Gehäuse 1 austreten

Die Dichtung 6 kann vorzugsweise eine elastische Dichtung sein, insbesondere aus einem Elastomer bestehen. Die Dichtung 6 ist mit zumindest einer ersten elektrisch leitenden Lage 10 in Kontakt, wobei im zusammengesetzten Zustand die elektrisch leitende Lage die Innenseite 13 des ersten Gehäuseteils 2 abdeckt.

Die Verbindung zwischen Dichtung 6 und der zumindest einen ersten elektrisch leitenden Lage 10 kann stoff- und/oder formschlüssig sein. Die elektrisch leitende Lage 10 kann auch lediglich auf die Dichtung gelegt werden und beim Zusammensetzten des ersten und zweiten Gehäuseteils 2, 4 werden die Dichtung 6 und die elektrisch leitende Lage 10 aneinandergedrückt.

Die elektrisch leitende Lage 10 muss nicht direkt an der Innenseite 13 des ersten Gehäuseteils 2 anliegen. Allerdings sollte die Lage 10 im Wesentlichen entlang der Innenseite 13 des zweiten Gehäuseteils verlaufen, so dass die elektrisch leitende Lage 10 zur elektromagnetischen Abschirmung des Gehäuses beitragen kann. Die elektromagnetisch abzuschirmenden Elemente sollen daher auf der Innenseite der elektrisch leitenden Lage 10 innerhalb des Gehäuses 1 im Bereich 14 angeordnet sein.

Insbesondere ist die elektrisch leitende Lage 10 mit zumindest einem Teil der Dichtung 6 überlappend ausgeführt. Dafür weist die Dichtung 6 vorzugsweise einen Anbindungs-Bereich 11 auf, mit dem die elektrisch leitende Lage 10 vorzugsweise überlappend ausgeführt ist.

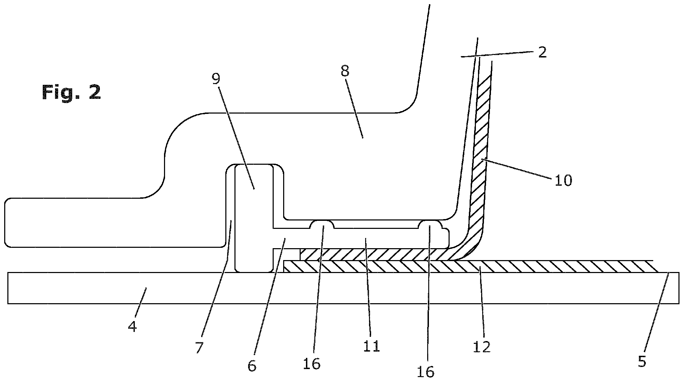

Dies kann beispielsweise genauer in Fig. 2 dargestellt werden, die ein Ausschnitt aus Fig. 1 zeigt.

Das erste Gehäuseteil 2 weist beispielsweise eine Nut 7 auf, in der ein Teil 9 der Dichtung 6 angeordnet ist.

Ferner weist die Dichtung im Bereich des Anbindungs-Bereichs 11 in dem in Fig. 2 dargestellten Ausführungsbeispiel zwei Vorsprünge 16 auf, die im in Fig. 2 dargestellten zusammengesetzten Zustand zusammengedrückt sind.

Durch die Vorsprünge 16 findet im zusammengesetzten Zustand eine lokale Verpressung der elektrisch leitenden Lage 10 statt.

Im dargestellten Ausführungsbeispiel ist ferner eine zweite elektrisch leitende Lage 12 vorgesehen, die entlang der Innenseite 5 des zweiten Gehäuseteils 4 verläuft. Durch die lokale Verpressung wird die erste elektrisch leitende Lage 10 und die zweite elektrisch leitende Lage 12 aneinandergepresst, so dass die elektromagnetische Abschirmschirmung des Gehäuses vorzugsweise im Wesentlichen Spalt-frei sichergestellt ist. Beispielsweise Ebenheits-Toleranzen des Gehäuses können so ausgeglichen werden.

Das zweite Gehäuseteil 4 kann auch selbst elektrisch leitend sein und zum Beispiel ein Metalldeckel sein. In diesem Fall könnte die zweite elektrisch leitende Lage 12 weggelassen werden und die erste elektrisch leitende Lage direkt auf das zweite Gehäuseteil gedrückt werden.

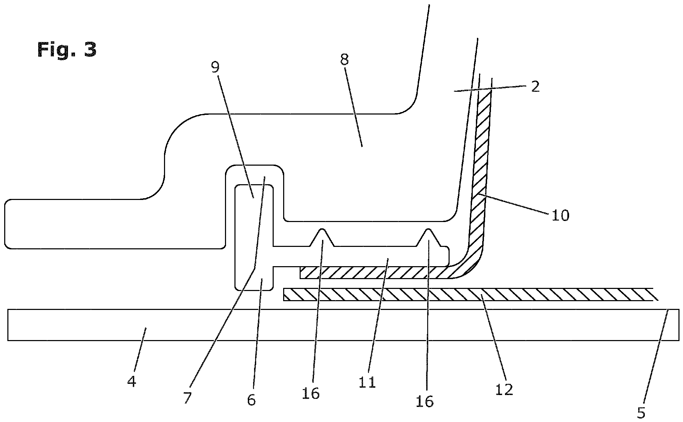

Im Fig. 3 ist das Ausführungsbeispiel nach Fig. 2 dargestellt im nicht zusammengesetzten Zustand. In diesem Zustand ist deutlich zu erkennen, dass die Vorsprünge 16 nicht zusammengedrückt sind.

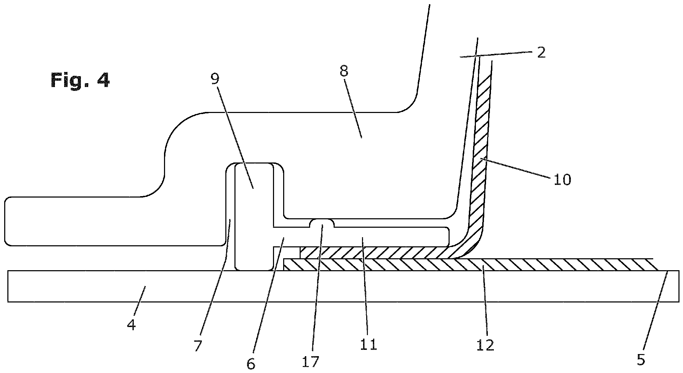

In Fig. 4 ist ein weiteres Ausführungsbeispiel dargestellt, das sich von dem vorherigen Ausführungsbeispiel dadurch unterscheidet, dass lediglich ein einzelner Vorsprung 17 vorgesehen ist, der im zusammengesetzten Zustand zusammengedrückt werden kann. Bereits solch ein einzelner Vorsprung kann eine lokale Verpressung im zusammengesetzten Zustand bewirken, wobei dadurch Toleranzen zwischen dem Gehäuseteil 2 und dem Gehäuseteil 4 ausgeglichen werden können.

Wenn die elektrisch leitende Lage 10 direkt mit der Dichtung 6 verbunden ist, kann eine formschlüssige Positionierung im Gehäuse stattfinden.

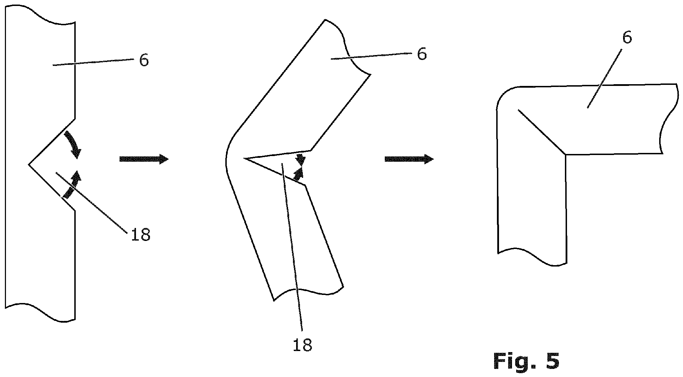

In Fig. 5 ist eine Dichtung 6 dargestellt, wobei aus Einfachheitsgründen kein Dichtungsbereich 9 und auch keine Vorsprünge 16 dargestellt sind. Die Dichtung kann insbesondere in dem Eckbereich eingeschnitten sein und erst dann für die Ecke geknickt werden, so dass im Eckbereich der Dichtung keine Quetschung des Dichtungsmaterials stattfindet. Die Form und die Größe des Einschnitts kann durch Versuche bestimmt werden, so dass einerseits keine Quetschung des Materials stattfindet und andererseits eine ausreichende Dichtung in diesem Bereich gewährleistet ist. Die elektrisch leitende Lage 10 kann, nach dem die Knickung ausgeführt worden ist, an die Dichtung stoff- oder formschlüssig oder kraftschlüssig angebracht werden.

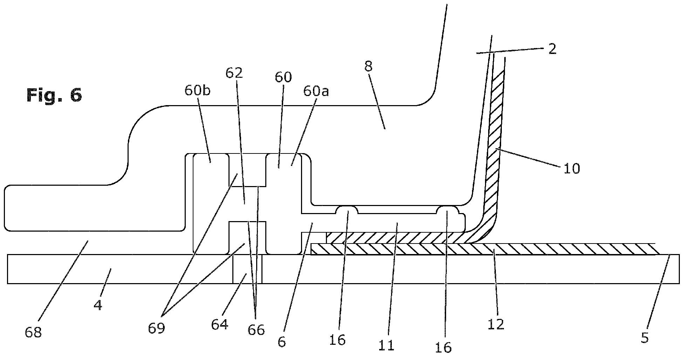

Fig. 6 zeigt ein Ausführungsbeispiel mit einer alternativen Ausführungsform für die Dichtung 6. Die Dichtung 6 weist einen Bereich auf, der wiederum ein Querschnittsprofil 60 mit beispielhafter H-förmiger Kontur, bestehend aus wenigstens einem inneren dichtenden Dichtabschnitt 60a und wenigstens einem äußeren dichtenden Dichtabschnitt 60b, die über einen Stegbereich 62 verbunden sind, aufweist, wobei zwischen dem inneren dichtenden Dichtabschnitt 60a und dem äußeren dichtenden Dichtabschnitt 60b des beispielhaften H-förmigen Dichtungsprofils 60 am ersten und/oder zweiten Gehäuseteils 2, 4 eine Prüfdrucköffnung 64 für den Anschluss von Druckluft bzw. eines Differenzdrucks zur Umgebung für die Dichtheitsprüfung der Dichtung vorgesehen ist. Der Stegbereich 62, der im Wesentlichen nicht im Kontakt mit dem ersten und/oder zweiten Gehäuseteil 2, 4 ist und vorzugsweise an wenigstens einer Stelle entlang des Dichtungsverlaufs einen Durchbruch für das Prüfgas aufweist, so dass das Prüfgas vorzugsweise auch bis zu den Kontaktflächen des inneren dichtenden Dichtabschnitts 60a und des äußeren dichtenden Dichtabschnitts 60b mit dem der Prüfdrucköffnung 64 gegenüberliegenden Gehäuseteils strömen kann und somit Undichtigkeiten der Dichtabschnitte 60a und 60b zu beiden Gehäusehälften erkannt werden können. Der vorzugsweise wenigstens eine Prüfgas-durchlassende Durchbruch im Stegbereich 62 führt zur Bildung eines zusammenhängenden Prüfvolumen 69.

Um die bestimmungsgemäße Abdichtung der Dichtabschnitte 60a, 60b gemäß Fig.6 prüfen zu können, ist das Abströmen des Prüfgases vom äußeren Dichtabschnitt 60b nach außen und vom inneren Dichtabschnitt 60a ins Innere des Gehäuses sicherzustellen. Um das Abströmen des Prüfgases zu ermöglichen, ist vorzugsweise wenigstens ein Kanal 68, vorzugsweise in Form wenigstens eines Spaltes, vom äußeren Dichtabschnitt 60b zur Umgebung vorzusehen und vorzugsweise ist wenigstens ein weiterer Kanal 68, vorzugsweise in Form wenigstens eines Spaltes, vom inneren Dichtabschnitt 60a ins Innere des Gehäuses vorzusehen. Wenn der Kontaktbereich des beispielhaften H-förmigen Dichtungsbereichs 60 bei der Prüfung undicht sein sollte, entweicht Luft über den wenigstens Kanal 68 in die Umgebung im Falle eines undichten äußeren Dichtabschnitts 60b und im Falle eines undichten inneren Dichtabschnitts 60a gelangt bei Vorliegen eines weiteren Kanals 68, Luft in das Gehäuseinnere 14. Dadurch kann ein Druckabfall gemessen werden und festgestellt werden, wenn die Dichtung 6 nicht dicht ist. Im Vergleich zu einer Dichtheitsprüfung der Dichtung über das gesamte große Fassungsvolumen des Gehäuses, lässt sich eine Dichtheitsprüfung der Dichtung über das deutlich kleinere zwischen den Dichtabschnitten 60a, 60b eingeschlossene Prüfvolumen 69 deutlich schneller und genauer prüfen.

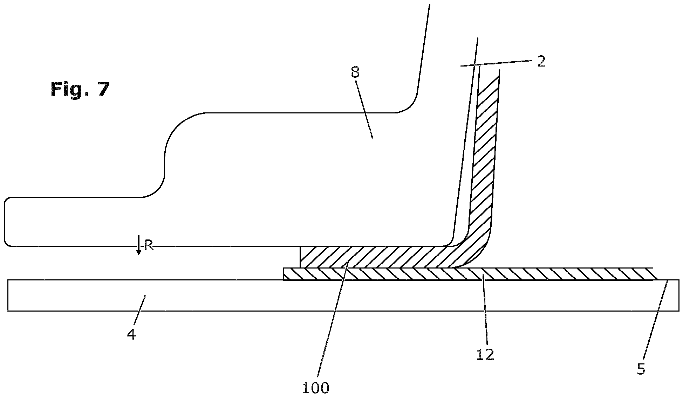

Fig. 7 zeigt ein alternatives Ausführungsbeispiel. Es unterscheidet sich dadurch, dass das komprimierbare Element und die zumindest eine erste elektrisch leitende Lage eine gemeinsame Schicht 100 bilden. Dies bedeutet, dass die gemeinsame Schicht sowohl die Eigenschaften des komprimierbaren Elements als auch der elektrisch leitenden Lage aufweist. Die gemeinsame Schicht 100 ist vorzugsweise als Flachmaterial ausgebildet. Sie ist vorzugsweise in Dickenrichtung R verpressbar.

Die gemeinsame Schicht ist im dargestellten Ausführungsbeispiel in Kontakt mit der zweiten elektrisch leitenden Lage 12, die entlang der Innenseite 5 des zweiten Gehäuseteils 4 verläuft.

Durch die Kontaktierung der gemeinsamen Schicht 100 und der zweiten elektrisch leitende Lage 12 ist sichergestellt, dass die elektromagnetische Abschirmschirmung des Gehäuses gewährleistet ist.

Das zweite Gehäuseteil kann auch selbst elektrisch leitend sein und zum Beispiel ein Metalldeckel sein. In diesem Fall könnte die zweite elektrisch leitende Lage 12 weggelassen werden und die gemeinsame Schicht 100 auf das zweite Gehäuseteil gedrückt werden.

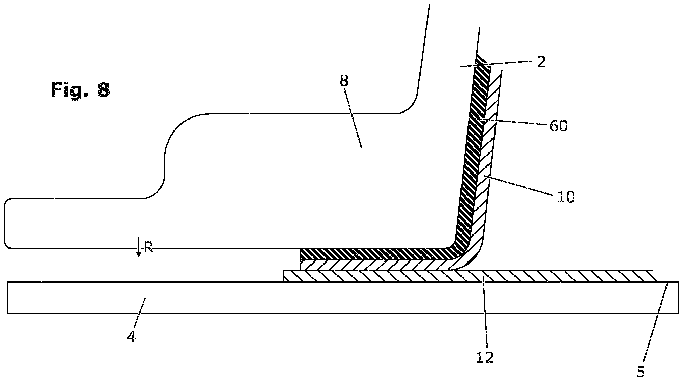

Fig. 8 zeigt ein weiteres alternatives Ausführungsbeispiel. Das zumindest eine komprimierbare Element 60 und die zumindest eine erste elektrisch leitende Lage 10 sind als Verbund-Flachmaterial ausgebildet, wobei zumindest das als Schicht ausgebildete komprimierbare Element 60 und/oder die erste elektrisch leitende Lage 10 in Dickenrichtung R verpressbar sind.

Die elektrisch leitende Lage 10 kontaktiert die zweite zweiten elektrisch leitende Lage 12, die entlang der Innenseite 5 des zweiten Gehäuseteils 4 verläuft. Das zweite Gehäuseteil kann auch selbst elektrisch leitend sein und zum Beispiel ein Metalldeckel sein. In diesem Fall könnte die zweite elektrisch leitende Lage 12 weggelassen werden und die erste elektrisch leitende Lage 10 auf das zweite Gehäuseteil gedrückt werden.

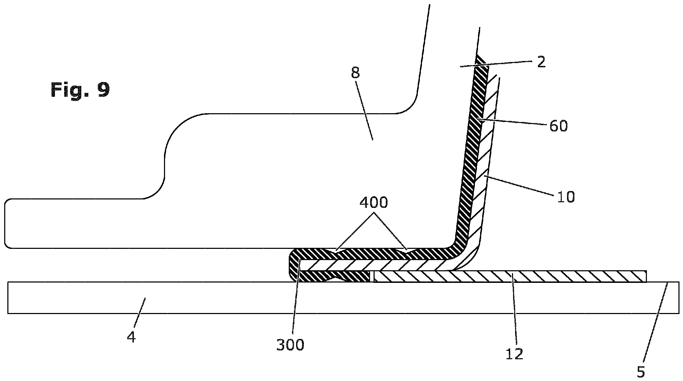

Fig. 9 zeigt ein weiteres alternatives Ausführungsbeispiel. Es ist ähnlich aufgebaut wie Figur 8 nur mit dem Unterschied, dass das zumindest das als Schicht ausgebildete komprimierbare Element 60 die zumindest eine elektrisch leitende Lage insbesondere im Bereich des umlaufenden Randes 300 oder in oder an der umlaufenden Kontur zumindest teilweise umschlingt.

Auch kann zusätzlich, wie im Ausführungsbeispiel in Fig. 9 dargestellt, das zumindest eine komprimierbare Element Einkerbungen 400 aufweisen.

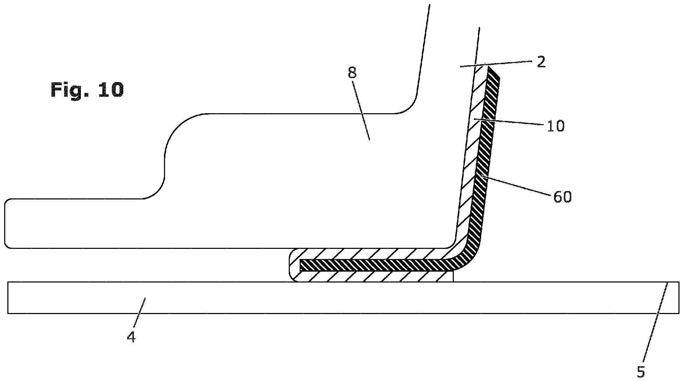

Fig. 10 zeigt ein weiteres alternatives Ausführungsbeispiel, bei dem die zumindest eine elektrisch leitende Lage 10 die zumindest eine komprimierbare Schicht 60 insbesondere im Bereich des umlaufenden Randes 8 oder in oder an der umlaufenden Kontur zumindest teilweise umschlingt. Im dargestellten Ausführungsbeispiel ist das zweite Gehäuseteil 4 selbst elektrisch leitend und kann zum Beispiel ein Metalldeckel sein. Die erste elektrisch leitende Lage 10 kontaktiert den zweiten Gehäuseteil 4. Alternativ kann auch wie in den vorherigen Ausführungsbeispielen gezeigt auch eine zweite elektrisch leitende Lage 12 vorgesehen sein, die die erste elektrisch leitende Lage 10 kontaktieren kann,

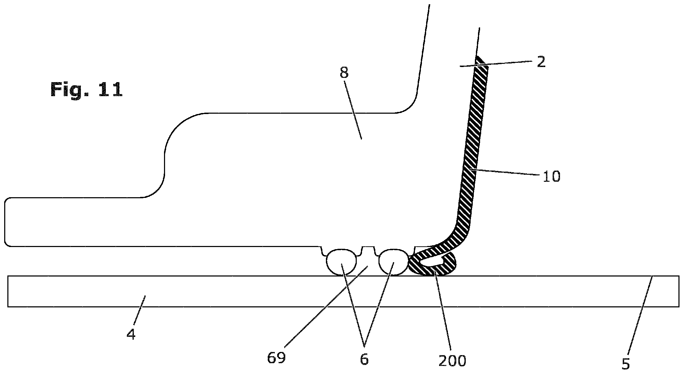

Fig. 11 zeigt ein weiteres alternatives Ausführungsbeispiel, bei dem zumindest ein Kantenbereich 200 der ersten elektrisch leitenden Lage 10 aufgerollt oder umgefaltet ist. Die erste elektrisch leitende Lage 10 kontaktiert mit dem aufgerollten oder umgefalteten Kantenbereich 200 sowohl das erste Gehäuseteil 2 als auch das zweite Gehäuseteil 4.

Bevorzugt weist die elektrisch leitende Lage 10 ein elastisches bzw. federndes Verhalten zumindest im aufgerollten oder umgefalteten Kantenbereich 200 auf, wodurch sich eine Anpresskraft auf das erste und zweite Gehäuseteil 2, 4 ergibt und die elektrisch leitende Lage 10 selbst eine Dichtfunktion bewirkt.

Um die Dichtwirkung der elektrisch leitenden Lage 10 zu erhöhen, falls die Anwendung es erfordert, ist es besonders bevorzugt in dem aufgerollten oder umgefalteten Kantenbereich 200 ein nicht dargestelltes elastisches Teil anzuordnen, mittels dessen die elektrisch leitende Lage 10 mit höherer Kraft sowohl gegen das erste Gehäuseteil 2 als auch gegen das zweite Gehäuseteil 4 drückbar ist.

Für noch höhere Dichtheitsanforderungen oder/und die schnellere Dichtungs-Dichtprüfbarkeit, wie zu Fig. 6 beschrieben, kann der Kantenbereich 200 der elektrisch leitenden Lage 10 so umgefaltet sein, dass sich zwei Dichtwulste ergeben oder
dass sich zwei parallel verlaufende Dichtverläufe durch ein zusätzliches elastisches parallel zum Kantenbereich 200 angeordnetes komprimierbares Element 6 ergeben.
oder dass, wie in Fig. 11 dargestellt, zwei parallel verlaufende komprimierbare Elemente 6 vorhanden sind, die die Dichtfunktion erfüllen und die Dichtungsprüfbarkeit ermöglichen und der aufgerollte oder umgefaltete Kantenbereich 200 keine Dichtfunktion aufweisen muss.

## Patentansprüche

1. Gehäuse (1) vorzugsweise für die Aufnahme von Elektrobauteilen, mit
- zumindest einem ersten Gehäuseteil (2) und zumindest einem zweiten Gehäuseteil (4), die in einem zusammengesetzten Zustand ein geschlossenes Gehäuse (1) bilden,
- wobei zumindest das erste Gehäuseteil (2) einen umlaufenden Rand (8) oder umlaufende Kontur im Randbereich aufweist,
- zumindest ein komprimierbares Element (6, 60), das zumindest auf dem umlaufenden Rand (8) oder in oder an der umlaufenden Kontur angeordnet ist, und das im zusammengesetzten Zustand zwischen dem ersten Gehäuseteil (2) und dem zweiten Gehäuseteil (4) angeordnet ist,
**dadurch gekennzeichnet,**
**dass** zumindest eine erste elektrisch leitenden Lage (10) vorgesehen ist, wobei im zusammengesetzten Zustand des Gehäuses (1) die erste elektrisch leitende Lage (10) die Innenseite (13) des ersten Gehäuseteils (2) abdeckt.

2. Gehäuse (1) nach Anspruch 1, **dadurch gekennzeichnet, dass** die erste elektrisch leitende Lage (10) im Bereich des umlaufenden Rands (8) sowohl das erste Gehäuseteil (2) als auch das zweite Gehäuseteil kontaktiert.

3. Gehäuse (1) nach Anspruch 1 oder 2, **dadurch gekennzeichnet, dass** zumindest ein Kantenbereich (200) der ersten elektrisch leitenden Lage (10) aufgerollt oder umgefaltet ist.

4. Gehäuse (1) nach Anspruch 3, **dadurch gekennzeichnet, dass**
- die erste elektrisch leitende Lage (10) mit dem aufgerollten oder umgefalteten Kantenbereich (200) sowohl das erste Gehäuseteil (2) als auch das zweite Gehäuseteil (4) kontaktiert, und /oder
- die erste elektrisch leitende Lage (10) mit dem aufgerollten oder umgefalteten Kantenbereich (200) mit dem komprimierbaren Element in Kontakt steht, wobei das komprimierbare Element vorzugsweise als Dichtung ausgebildet ist, und/oder
- in dem aufgerollten oder umgefalteten Kantenbereich (200) ein elastisches Teil angeordnet ist, mittels dessen die elektrisch leitende Lage (10) sowohl gegen das erste Gehäuseteil (2) als auch gegen das zweite Gehäuseteil (4) drückbar ist.

5. Gehäuse (1) nach einem der Ansprüche 1 bis 2, **dadurch gekennzeichnet, dass**
- das zumindest eine komprimierbare Element und die zumindest eine erste elektrisch leitende Lage eine gemeinsame Schicht (100) bilden, die als Flachmaterial ausgebildet ist, so dass die als Flachmaterial ausgebildete Schicht in Dickenrichtung verpressbar ist und/oder
- das zumindest eine komprimierbare Element (60) und die zumindest eine erste elektrisch leitende Lage (10) ein Verbund-Flachmaterial bilden, wobei zumindest das als Schicht ausgebildete komprimierbare Element (60) und/oder die erste elektrisch leitende Lage (10) in Dickenrichtung (R) verpressbar sind.

6. Gehäuse (1) nach Anspruch 5, **dadurch gekennzeichnet, dass**
- das zumindest eine als komprimierbare Schicht ausgebildete komprimierbare Element (60) die zumindest eine elektrisch leitende Lage (10) insbesondere im Bereich des umlaufenden Randes oder in oder an der umlaufenden Kontur zumindest teilweise umschlingt und/oder
- das zumindest eine als komprimierbare Schicht ausgebildete komprimierbare Element (60) Einkerbungen (400) aufweist, und/oder
- die zumindest eine elektrisch leitende Lage (10) das zumindest eine als komprimierbare Schicht ausgebildete komprimierbare Element (60) insbesondere im Bereich des umlaufenden Randes oder in oder an der umlaufenden Kontur zumindest teilweise umschlingt.

7. Gehäuse (1) nach einem der Ansprüche 1 bis 2, **dadurch gekennzeichnet, dass** das zumindest eine komprimierbare Element (6) als Dichtung ausgebildet ist, wobei die Dichtung und die erste elektrisch leitende Lage (10) in Kontakt miteinander stehen.

8. Gehäuse (1) nach Anspruch 7, **dadurch gekennzeichnet, dass**
- die Dichtung (6) adhäsiv auf dem ersten Gehäuseteil (2) angebunden ist und/oder
- die Dichtung (6) auf dem ersten Gehäuseteil (2) aufgesetzt ist, und/oder
- der Kontakt zwischen Dichtung (6) und elektrisch leitender Lage (10) durch zumindest partielles Aufeinanderlegen hergestellt ist und/oder eine formschlüssige und/oder kraftschlüssige und/oder adhäsive Verbindung als Kontakt vorliegt, und/oder
- die Dichtung (6) und die elektrisch leitende Lage (10) eine gemeinsame Baugruppe bilden, und/oder
- die Dichtung (6) zumindest einen Anbindungs-Bereich (11) aufweist, mit dem die elektrisch leitende Lage (10) in Kontakt ist, wobei vorzugsweise der Anbindungs-Bereich (11) und die elektrisch leitende Lage (10) im zusammengesetzten Zustand zumindest teilweise einander überlappend angeordnet sind.

9. Gehäuse (1) nach Anspruch 8, **dadurch gekennzeichnet, dass**
- der Anbindungs-Bereich (11) ein an die Dichtung (6) angeformter Bereich ist, der im zusammengesetzten Zustand auf der der Gehäuseinnenseite zugewandten Seite der Dichtung (6), bzw. auf der mit dem Fassungsvolumen des Gehäuses (1) in Kontakt stehenden Seite der Dichtung angeordnet ist, und/oder
- der Anbindungs-Bereich (11) ein Teil der Dichtung (6) ist, der vorzugsweise in Relation zu dem restlichen Teil der Dichtung (6) eine geringere Höhe aufweist, wobei der Anbindungs-Bereich (11) vorzugsweise eine Lasche ist., und/oder
- der Anbindungs-Bereich (11) sich über die vollständige Breite der Dichtung (6) erstreckt, d.h. über die dem zweiten Gehäuseteil (4) zugewandten Oberfläche der Dichtung (6), und/oder
- der zumindest eine Anbindungs-Bereich (11) ein umlaufender Teil der Dichtung (6) ist.

10. Gehäuse (1) nach Anspruch 7 bis 9, **dadurch gekennzeichnet, dass**
- mehrere umlaufende Anbindungs-Bereiche (11) vorgesehen sind, die vorzugsweise entlang des Dichtungsverlaufs im Wesentlichen gleichmäßige Abstände zueinander aufweisen und/oder
- der Anbindungs-Bereich (11) im zusammengesetzten Zustand zumindest teilweise zusammengedrückt ist, und/oder
- die Dichtung, insbesondere der Anbindungs-Bereich (11) zumindest einen, vorzugsweise mindestens zwei Vorsprünge aufweist,
- der zumindest einen Vorsprung (16) im zusammengesetzten Zustand zumindest teilweise zusammengedrückt ist, und/oder
- der zumindest einen Vorsprung (16) in der Richtung hervorsteht, in der im zusammengesetzten Zustand die auf die Dichtung wirkende Kraft einwirkt.

11. Gehäuse (1) nach einem der Ansprüche 7 bis 10, **dadurch gekennzeichnet, dass**
- das zweite Gehäuseteil (4) elektrisch leitend ist, und/oder
- eine zweite elektrisch leitende Lage (12) vorgesehen ist, die im zusammengesetzten Zustand die Innenseite des zweiten Gehäuseteils (4) abdeckt, wobei vorzugsweise die erste und zweite Lage (10, 12) im zusammengesetzten Zustand in Kontakt stehen.

12. Gehäuse (1) nach einem der Ansprüche 7 bis 11, **dadurch gekennzeichnet, dass**
- die Dichtung (6) in wenigstens einem Bereich aus wenigstens zwei zueinander beabstandeten Dichtbereichen besteht, zwischen denen wenigsten ein geschlossenes Volumen 69 ausgebildet ist, , wobei zwischen den wenigstens zwei beabstandeten Dichtbereichen wenigstens eine Prüfdruckbohrung (64) für die Aufbringung eines Differenzdrucks für die Dichtheitsprüfung der Dichtung vorgesehen ist und/oder
- die wenigstens zwei zueinander beabstandeten Dichtbereiche über wenigstens einen Stegbereich (62) miteinander verbunden sind und die wenigstens zwei zueinander beabstandeten Dichtbereiche mit dem wenigstens einen Stegbereich (62) vorzugsweise ein H-förmiges Querschnittsprofil (60) ausbilden.

13. Gehäuse (1) zur Aufnahme zumindest einer Batteriezelle umfassend wenigstens eine Dichtung (6) und wenigstens eine elektrisch leitfähige Lage (10, 12) gemäß einem der Ansprüche 7 bis 12, zur Abdichtung und elektromagnetischen Abschirmung der zumindest einen in dem Batteriegehäuse aufgenommenen Batteriezelle und elektrischen Komponenten.

14. Dichtung zum Einsetzen in ein Gehäuse nach einem der Ansprüche 7 bis 13, **dadurch gekennzeichnet, dass**
- die Dichtung (6) eine umlaufende Dichtung ist, die mit zumindest einer ersten elektrisch leitenden Lage (10, 12) in Kontakt ist und/oder
- die umlaufende Dichtung (6) mit dem umlaufenden Randbereich der ersten elektrischen leitenden Lage (10) verbunden ist, und/oder
- die Dichtung (6) einen Anbindungs-Bereich (11) aufweist, mit dem die elektrisch leitende Lage (10, 12) kontaktiert ist und wobei der Anbindungs-Bereich (11) und die elektrisch leitende Lage (10, 12) vorzugsweise einander überlappend angeordnet sind, und/oder
- die die erste elektrisch leitende Lage (10) derart ausgebildet ist, dass sie im eingesetzten Zustand in einem Gehäuse, diese im Bereich des umlaufenden Rands (8) sowohl das erste Gehäuseteil (2) als auch das zweite Gehäuseteil kontaktiert.

15. Verwendung eines Gehäuses nach einem der Ansprüche 1 bis 14 zur Aufnahme von elektrischen Komponenten, wie beispielsweise elektrischer Energiespeicher und/oder elektrischer Schaltungen.
